# EUROPÄISCHE PATENTSCHRIFT

(11) **EP 3 391 067 B1**
(45) Veröffentlichungstag und Bekanntmachung des Hinweises auf die Patenterteilung: **28.08.2019**
(21) Anmeldenummer: 16815754.3
(22) Anmeldetag: 06.12.2016
(51) Int. Cl.: G01R 31/3842

(54) **VERFAHREN ZUR BESTIMMUNG DER ALTERUNG EINES ELEKTROCHEMISCHEN SPEICHERS**
METHOD FOR DETERMINING THE AGEING OF AN ELECTROCHEMICAL STORAGE MEANS
PROCÉDÉ DE DÉTERMINATION DU VIEILLISSEMENT D'UN ACCUMULATEUR ÉLECTROCHIMIQUE

(30) Priorität: 04.02.2016 DE 102016201710; 24.11.2016 DE 102016223326
(43) Veröffentlichungstag der Anmeldung: 24.10.2018
(73) Patentinhaber: Siemens Aktiengesellschaft, 80333 München (DE)
(72) Erfinder: BETZIN, Christopher, 91301 Forchheim (DE); WOLFSCHMIDT, Holger, 91058 Erlangen (DE)
(86) Internationale Anmeldenummer: PCT/EP2016/079832
(87) Internationale Veröffentlichungsnummer: WO 2017/133813

(56) Entgegenhaltungen:
- US-A1- 2006 166 052
- US-A1- 2015 002 105

## Beschreibung

Die vorliegende Erfindung betrifft ein Verfahren zur Bestimmung der Alterung beziehungsweise des Alters eines elektrochemischen Speichers, und zwar einer Lithium-Ionen-Zelle. Elektrochemische Speicher, insbesondere Lithium-Ionen-Zellen, erfordern für einen wirtschaftlichen Betrieb eine lange Lebensdauer. Generell sollte der elektrochemische Speicher sowohl eine niedrige kalendarische Alterung als auch eine hohe Zyklenzahl gewährleisten können.

Zur Bestimmung der Alterung eines elektrochemischen Speichers existiert gemäß des Standes der Technik eine Mehrzahl von Verfahren.

In der EP 2389703 A1 wird die Aufnahme eines Impedanzspektrums zur Bestimmung der Alterung einer Batteriezelle vorgeschlagen.

In der EP 1450173 A2 wird die Alterung eines elektrochemischen Speichers mittels voller Lade- und Entladezyklen bestimmt. Hierzu muss der elektrochemische Speicher jedoch von seinem vorgesehenen Betrieb abgekoppelt werden.

Ein weiteres Verfahren ist in US2006166052 A1 beschrieben.

Der vorliegenden Erfindung liegt die Aufgabe zugrunde, ein verbessertes Verfahren zur Bestimmung der Alterung eines elektrochemischen Speichers bereitzustellen.

Die Aufgabe wird durch ein Verfahren mit den Merkmalen des unabhängigen Patenanspruches 1 gelöst. In den abhängigen Patentansprüchen sind vorteilhafte Ausgestaltungen und Weiterbildungen der Erfindung angegeben.

Das erfindungsgemäße Verfahren, das durch die Merkmale des Anspruchs 1 definiert ist, zur Bestimmung der Alterung ***SOH*** eines elektrochemischen Speichers umfasst die folgenden Schritte:
- Ermittlung eines ersten Voltammogramms mittels einer zyklischen Voltammetrie zu einem ersten Zeitpunkt;
- Ermittlung eines zweiten Voltammogramms mittels einer weiteren zyklischen Voltammetrie zu einem bezüglich des ersten Zeitpunktes späteren zweiten Zeitpunkt;
- Ermittlung eines ersten Extremwertes im ersten Voltammogram und eines zweiten Extremwertes im zweiten Voltammogramm, wobei jedem Extremwert wenigstens eine Spannung ***U*₁, *U*₂** und eine Stromstärke ***I*₁, *I*₂** zugehörig ist; und
- Bestimmung der Alterung ***SOH*** des elektrochemischen Speichers in Abhängigkeit eines Unterschiedes zwischen dem ersten und zweiten Extremwert.

Vorteilhafterweise wird durch die Erfindung die Alterung des elektrochemischen Speichers mittels eines Vergleichs zwischen dem ersten und zweiten Voltammogramm ermöglicht. Hierzu wird der Unterschied zwischen dem ersten und zweiten Extremwert herangezogen. Während der Alterung des elektrochemischen Speichers ändert sich sein Voltammogramm vom ersten Voltammogramm zum zweiten Voltammogramm. Besonders deutlich ist diese Änderung an den Extremwerten des jeweiligen Voltammogramms erkennbar, sodass der Unterschied der Extremwerte erfindungsgemäß zur Bestimmung der Alterung herangezogen wird.

Weiterhin ermöglicht das Verfahren die Bestimmung der Alterung des elektrochemischen Speichers während seines anwendungsgemäßen Betriebes, da die Voltammogramme parallel zum genannten Betrieb aufgenommen werden können, sodass der elektrochemische Speicher möglichst wenig gestört wird. Ferner führt die Ermittlung der Voltammogramme zu keiner zusätzlichen Alterung des elektrochemischen Speichers.

Der Erfindung liegt daher die Erkenntnis zugrunde, dass die Änderung der Extremwerte (Unterschied zwischen dem ersten und zweiten Extremwert) der aufgenommenen Voltammogramme (erstes und zweites Voltammogramm) mit der Alterung des elektrochemischen Speichers korreliert.

Ein weiterer Vorteil der vorliegenden Erfindung ist, dass zur Bestimmung der Alterung keine Vollzyklen, das heißt keine Lade- und/oder Entladezyklen erforderlich sind. Insbesondere muss der elektrochemische Speicher oder ein System, das den elektrochemischen Speicher umfasst, nicht während seines anwendungsgemäßen Betriebes zur Bestimmung seiner Alterung abgekoppelt werden. Das ist deshalb der Fall, da die Extremwerte unmittelbar aus den Voltammogrammen ermittelt werden können. Damit ermöglicht das erfindungsgemäße Verfahren einen Remote-Zugriff auf den Alterungszustand, das heißt auf die Alterung des elektrochemischen Speichers, ohne beispielsweise eine Servicekraft am Ort des elektrochemischen Speichers einzusetzen. Weiterhin erlaubt die Speicherung und Auswertung der Extremwerte eine Vorausschau (engl. Forecast), die es ermöglicht, die Alterung des elektrochemischen Speichers im zukünftigen Betrieb vorherzusagen oder zu bestimmen.

Die zyklische Voltammetrie, die zur Untersuchung elektrochemischer Vorgänge verwendet wird, erfolgt typischerweise mittels eines konstanten Spannungsvorschubs. Hierbei wird der elektrochemische Speicher mit einem konstanten Spannungsvorschub beaufschlagt und seine Stromantwort, das heißt die Stromstärke, gemessen. Dadurch können die elektrochemischen Prozesse innerhalb des elektrochemischen Speichers erfasst und charakterisiert werden. Je nach vorliegendem elektrochemischem Prozess ändert sich die erfasste beziehungsweise gemessene Stromstärke, sodass diese charakteristische Merkmale, beispielsweise Extremwerte (erster und zweiter Extremwert) aufweist. Die genannten charakteristischen Merkmale, das heißt der erste und zweite Extremwert sind alterungsabhängig, sodass erfindungsgemäß aus einem Vergleich, das heißt aus der Ermittlung des Unterschiedes zwischen dem ersten und zweiten Extremwert, die Alterung des elektrochemischen Speichers bestimmt werden kann.

Vorteilhafterweise kann zusätzlich durch die Bestimmung der Alterung des elektrochemischen Speichers eine optimierte Betriebsweise des elektrochemischen Speichers erfolgen.

Gemäß einer vorteilhaften Ausgestaltung der Erfindung wird der Unterschied durch die numerische Differenz **Δ*U* = *U*₁ *- U*₂** der den Extremwerten (41, 42) zugehörigen Spannungen ***U*₁, *U*₂** gebildet.

Mit anderen Worten wird die Verschiebung der Extremwerte in den Voltammogrammen, das heißt die Verschiebung des zweiten Extremwertes gegenüber dem ersten Extremwert, als Maß für die Alterung des elektrochemischen Speichers herangezogen. Hierbei bezieht sich die Verschiebung auf die den Extremwerten zugehörigen Spannungen.

Vorteilhafterweise wird dadurch ein besonders effizientes Verfahren zur Bestimmung der Alterung des elektrochemischen Speichers bereitgestellt.

Hierbei ist es besonders bevorzugt, die Alterung ***SOH*** durch ***SOH* = 1** - **|Δ*U*|/U₀** zu bestimmen, wobei ***U*₀** im Bereich von 10 mV bis 50 mV liegt. Besonders bevorzugt ist ein Wert von ***U*₀** von 30 mV.

In einer weiteren vorteilhaften Ausgestaltung der Erfindung wird der Unterschied durch die numerische Differenz **Δ*I* = *I*₁ - *I*₂** der den Extremwerten zugehörigen Stromstärken ***I*₁, *I*₂** gebildet.

Mit anderen Worten wird zur Bestimmung der Alterung die Änderung der Höhe der Extremwerte vom ersten Voltammogramm zum zweiten Voltammogramm herangezogen. Dadurch wird eine besonders effiziente Bestimmung der Alterung des elektrochemischen Speichers ermöglicht, da die Stromstärke besonders genau erfasst werden kann.

Hierbei ist es besonders bevorzugt, die Alterung ***SOH*** durch ***SOH* = 1** - **|Δ*I*|/*I*₀** zu bestimmen, wobei ***I*₀** im Bereich von 100 mA bis 500 mA liegt. Besonders bevorzugt ist ein Wert von ***I*₀** von 400 mA.

Gemäß einer vorteilhaften Ausgestaltung der Erfindung wird ein dritter Extremwert im ersten Voltammogramm und ein vierter Extremwert im zweiten Voltammogramm mit jeweils zugehörigen Spannungen ***U*₃, *U*₄** und Stromstärken ***I*₃**, ***I*₄** ermittelt, wobei der erste und zweite Extremwert einer Redoxreaktion und der dritte und vierte Extremwert einer Oxidationsreaktion des elektrochemischen Energiespeichers zugeordnet sind.

Typischerweise weist der Kurvenverlauf eines Voltammogramms wenigstens zwei Zweige auf, wobei der erste Zweig zu positiven Werten der Stromstärke und der zweite Zweig zu negativen Werten der Stromstärke korrespondiert. Der erste Zweig entspricht der Redoxreaktion innerhalb des elektrochemischen Speichers. Der zweite Zweig ist einer Oxidationsreaktion innerhalb des elektrochemischen Speichers zugeordnet.

Vorteilhafterweise kann durch das Heranziehen des dritten und vierten Extremwertes und durch einen Vergleich zwischen dem dritten/vierten Extremwert mit dem ersten/zweiten Extremwert eine besonders genaue Bestimmung der Alterung des elektrochemischen Speichers erfolgen.

Besonders bevorzugt ist es hierbei, den Unterschied durch die numerische Differenz **(*I*₁ + |*I*₃|) - (*I*₂ - |*I*₄|)** zu bilden.

Weiterhin ist es besonders vorteilhaft, den Unterschied durch den nummerischen Quotienten **[*I*₂/(*I*₂ + *I*₄)]/[*I*₁/(*I*₁ + *I*₃₎]** zu bilden.

Vorteilhafterweise wird dadurch die Bestimmung der Alterung des elektrochemischen Speichers weiter verbessert, da mehrere Extremwerte (erster, zweiter, dritter und vierter Extremwert) zur Bestimmung der Alterung herangezogen werden. Aus dem genannten Unterschied lässt sich dann die Alterung des elektrochemischen Speichers, beispielsweise durch eine Kalibrierung, bestimmen. Bei der Kalibrierung wird die absolute Beziehung zwischen dem ermittelten Unterschied und der Alterung *(SOH-*Wert) festgelegt, sodass durch die Ermittlung des Unterschiedes die Alterung bestimmt werden kann.

Weiterhin ist es von Vorteil, den Unterschied durch den numerischen Quotienten **(*I*₁ - *I*₃)/(*I*₂ - *I*₄)** zu bilden.

Dadurch kann die Bestimmung der Alterung des elektrochemischen Speichers weiter verbessert werden.

In einer besonders bevorzugten Ausgestaltung der Erfindung wird der Unterschied durch den Winkel **Δ*α*** zwischen einer ersten und einer zweiten Gerade gebildet, wobei die erste Gerade durch den ersten und dritten Extremwert und die zweite Gerade durch den zweiten und vierten Extremwert festgelegt wird.

Insbesondere ist es hierbei bevorzugt, die Alterung ***SOH*** durch ***SOH* = 1 - |Δ*α*|/*α*₀** zu bestimmen, wobei ***α*₀** im Bereich von 5 Grad bis 15 Grad liegt. Besonders bevorzugt ist ein Wert von ***α*₀** von 10 Grad. Hierbei wird auch **Δ*α*** in Grad bestimmt.

In der Erfindung wird als elektrochemischer Speicher eine Lithium-Ionen-Zelle verwendet.

Das ist deshalb von Vorteil, da Lithium-Ionen-Zellen besonders deutliche Extremwerte innerhalb ihrer Voltammogramme aufweisen. Diese können dann einfach erkannt und zur Bestimmung der Alterung der Lithium-Ionen-Zellen herangezogen werden. Weiterhin sind Lithium-Ionen-Zellen erfindungsgemäße elektrochemische Speicher.

Erfindungsgemäß ist es hierbei, den ersten und/oder zweiten Extremwert als einen Spitzenwert der Stromstärke im Bereich von 3,4 V bis 3,7 V, insbesondere bei 3,6 V, festzulegen.

Das ist deshalb von Vorteil, da es sich bei dem Extremwert bei etwa 3,6 V um eine Redoxreaktion handelt, und somit die Gleichgewichtsspannung des dortigen Phasenübergangs von der Inter/Dekalation des Lithiums in/aus NCA resultiert oder handelt. Es ergeben sich hierbei Übergangspotentiale, um die Redoxreaktion zu forcieren, welche dazu führen, dass die Extremwerte verschoben werden. Beispielsweise nimmt die Höhe der Extremwerte vom ersten Voltammogramm zum zweiten Voltammogramm deutlich ab. Aus der Änderung der Höhe (Stromstärke) der Extremwerte kann dann eine eindeutige Zuordnung der Alterung erfolgen.

Bevorzugt ist es hierbei, als Spannungsvorschub der ersten und/oder der zweiten zyklischen Voltammetrie einen Wert im Bereich von 0,01 mV/s bis 0,03 mV/s zu verwenden. Dadurch werden in Bezug auf die Alterung des elektrochemischen Speichers vorteilhafte Voltammogramme ermittelt. Insbesondere zeigen diese deutliche Extremwerte, die zur Bestimmung der Alterung des elektrochemischen Speichers herangezogen werden können.

In einer vorteilhaften Weiterbildung der Erfindung wird als elektrochemischer Speicher ein Energiespeicher eines Luftfahrzeuges, insbesondere eines Elektroflugzeuges, verwendet.

Das ist deshalb der Vorteil, da das vorliegende erfindungsgemäße Verfahren eine Bestimmung der Alterung unabhängig von dem Betrieb des elektrochemischen Speichers ermöglicht. Mit anderen Worten kann die Alterung des elektrochemischen Speichers während seines anwendungsgemäßen Betriebes erfasst werden, ohne den Betrieb zu stören oder zu unterbrechen. Dies ist besonders bei Elektroflugzeugen von Vorteil, da diese typischerweise stetig während ihres Betriebes in der Luft, durch den elektrochemischen Speicher mit Energie versorgt werden müssen. Weiterhin wird dadurch die Betriebssicherheit des Luftfahrzeuges erhöht.

Insbesondere ist der elektrochemische Speicher für den Antrieb des Elektroflugzeuges vorgesehen. Mit anderen Worten umfasst das Elektroflugzeug einen elektrochemischen Speicher, dessen Alterung mittels des erfindungsgemäßen Verfahrens oder einer seiner Ausgestaltungen, beispielsweise während des Flugbetriebes des Elektroflugzeuges, bestimmt wird. Dadurch kann die Betriebssicherheit des Elektroflugzeuges gesteigert werden.

Weitere Vorteile, Merkmale und Einzelheiten der Erfindung ergeben sich aus den im Folgenden beschriebenen Ausführungsbeispielen sowie anhand der Zeichnungen. Dabei zeigen schematisiert:
- Figur 1: ein erstes und zweites Voltammogramm eines elektrochemischen Speichers; und
- Figur 2: ein weiteres erstes und zweites Voltammogramm eines elektrochemischen Speichers.

Gleichartige, gleichwertige oder gleichwirkende Elemente können in den Figuren mit denselben Bezugszeichen versehen sein.

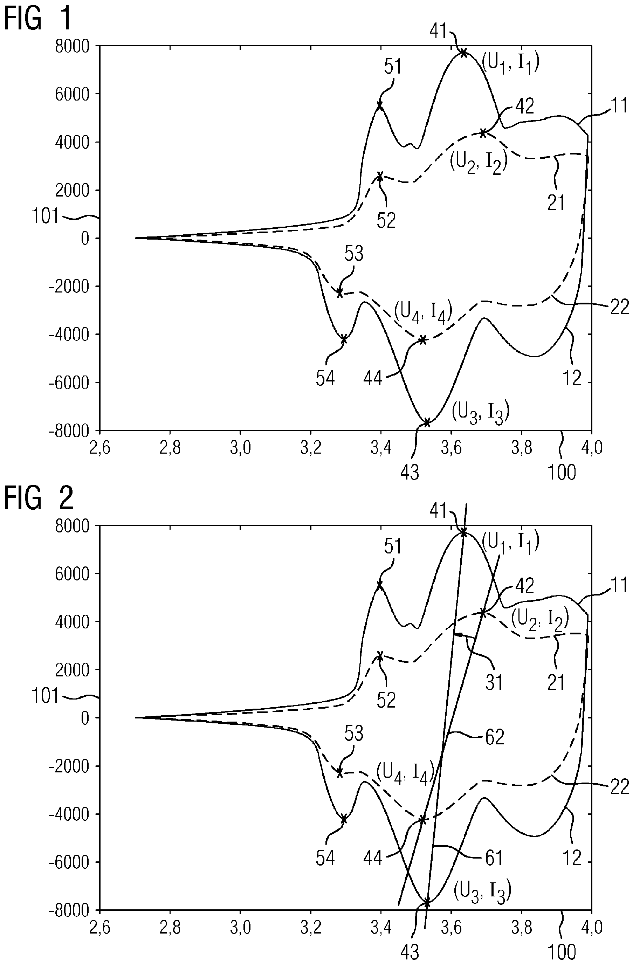

Figur 1 zeigt ein erstes Voltammogramm 11, 12 und ein zweites Voltammogramm 21, 22. Das erste Voltammogramm 11, 12 ist aus einem ersten Zweig 11 und einem zweiten Zweig 12 gebildet. Das zweite Voltammogramm 21, 22 ist ebenfalls aus einem ersten Zweig 21 und einem zweiten Zweig 22 gebildet.

Die Voltammogramme 11, 12, 21, 22 sind mittels eines Spannungsvorschubes, beispielsweise mit 0,01 mV/s, ermittelt worden. Die aktuelle Spannung am elektrochemischen Speicher ist an der Abszisse 100 des dargestellten Diagramms aufgetragen. Die erfasste Antwort des elektrochemischen Speichers auf die aktuell anliegende Spannung, die durch die Stromstärke gegeben ist, ist an der Ordinate 101 des dargestellten Diagramms verdeutlicht.

Das erste Voltammogramm 11, 12 ist zu einem früheren Zeitpunkt ermittelt worden als das zweite Voltammogramm 21, 22. Deutlich ist der Unterschied zwischen dem ersten Voltammogramm 11, 12 und dem zweiten Voltammogramm 21, 22 zu erkennen. Das erste Voltammogramm 11, 12 und das zweite Voltammogramm 21, 22 weisen eine Mehrzahl von Extremwerten (engl. Peaks) auf. Hierbei liegt ein erster Extremwert 41 bei etwa 3,6 V vor. Ein zweiter Extremwert 42 ist bezüglich des ersten Extremwertes 41 leicht nach rechts verschoben. Weiterhin ist die Höhe (Stromstärke) des zweiten Extremwertes 42 im Vergleich zur Stromstärke des ersten Extremwertes 41 reduziert. Aus der Verschiebung, das heißt aus dem Spannungsunterschied zwischen dem ersten Extremwert 41 und dem zweiten Extremwert 42 und/oder aus dem Höhenunterschied, das heißt aus dem Unterschied der Stromstärke des ersten Extremwertes 41 und des zweiten Extremwertes 42, kann die Alterung des elektrochemischen Speichers bestimmt werden.

Der erste Zweig 11 (Redoxzweig) des ersten Voltammogramms 11, 12 korrespondiert zu einer Redoxreaktion innerhalb des elektrochemischen Speichers. Der zweite Zweig 12 (Oxidationszweig) des ersten Voltammogramms 11, 12 korrespondiert zu einer Oxidationsreaktion innerhalb des elektrochemischen Speichers. Analog korrespondiert der erste Zweig 21 des zweiten Voltammogramms 21, 22 zu einer Redoxreaktion und der zweite Zweig 22 des zweiten Voltammogramms 21,22 zu einer Oxidationsreaktion innerhalb des elektrochemischen Speichers.

Der erste sowie der zweite Extremwert 41, 42 liegen jeweils auf dem ersten Zweig 11, 21 (Redoxzweig).

Ein weiterer dritter sowie vierter Extremwert 43, 44 liegen auf dem Oxidationszweig 12, 22 des jeweiligen Voltammogramms 11, 12, 21, 22. Auch der dritte und vierte Extremwert 43, 44 kann analog zum ersten und zweiten Extremwert 41, 42 zur Bestimmung der Alterung des elektrochemischen Speichers herangezogen werden.

Die in Figur 1 dargestellten Voltammogramme 11, 12, 21, 22 weisen weitere Extremwerte 51, 52, 53, 54 auf, die analog zum ersten, zweiten, dritten und vierten Extremwert 41, 42, 43, 44 zur Bestimmung der Alterung ausschließlich oder ergänzend herangezogen werden können.

Weiterhin sind Mischformen vorstellbar. Beispielsweise wird die Alterung durch die Änderung der Stromstärke zwischen den Extremwerten und die Änderung der Spannungen zwischen den Extremwerten bestimmt.

Figur 2 zeigt im Wesentlichen die gleichen Voltammogramme 11, 12, 21, 22 wie bereits Figur 1. In Figur 2 ist dargestellt, wie die Alterung des elektrochemischen Speichers aus der Bestimmung eines Winkels **Δ*α*** 31 zwischen Extremwerten der Voltammogramme 11, 12, 21, 22 erfolgen kann. Hierbei zeigt Figur 2 im Wesentlichen dieselben Elemente wie bereits Figur 1.

Das erste Voltammogramm 11, 12 weist einen ersten Extremwert 41 sowie einen dritten Extremwert 43 auf. Das zweite Voltammogramm 21, 22 weist einen zweiten Extremwert 42 sowie einen vierten Extremwert 44 auf.

Durch den ersten Extremwert 41 und den dritten Extremwert 43 ist eine erste Gerade 61 definiert, die zu einer zweiten Gerade 62, die durch den zweiten Extremwert 42 und den vierten Extremwert 44 definiert ist, den Winkel 31 aufweist. Der Winkel 31 stellt ein Maß für die Alterung des elektrochemischen Speichers dar, sodass aus der hier dargestellten Bestimmung des Winkels 31 zwischen der ersten und zweiten Gerade 61, 62 die Alterung des elektrochemischen Speichers bestimmt werden kann.

Weiterhin können zusätzliche Extremwerte 51, 52, 53, 54 zur Bestimmung der Alterung herangezogen werden. Hierbei wird die erste Gerade dann durch die Extremwerte 51, 54 und die zweite Gerade durch die Extremwerte 52, 53 definiert. Auch hier würde sich ein Winkel zwischen den genannten Geraden ergeben, der zur Bestimmung der Alterung des elektrochemischen Speichers ausschließlich oder ergänzend herangezogen werden kann.

Die in Figur 1 dargestellten Verfahren zur Bestimmung der Alterung können mit dem in Figur 2 verdeutlichten Verfahren zur Bestimmung der Alterung des elektrochemischen Speichers kombiniert werden. Zur Bestimmung der Alterung des elektrochemischen Speichers wird somit wenigstens ein Paar von Extremwerten herangezogen.

Obwohl die Erfindung im Detail durch die bevorzugten Ausführungsbeispiele näher illustriert und beschrieben wurde, so ist die Erfindung nicht durch die offenbarten Beispiele eingeschränkt oder andere Variationen können vom Fachmann hieraus abgeleitet werden, ohne den Schutzumfang der Erfindung zu verlassen.

## Patentansprüche

1. Verfahren zur Bestimmung der Alterung ***SOH*** einer Lithium-Ionen-Zelle, umfassend die Schritte:
- Ermittlung eines ersten Voltammogramms (11, 12) mittels einer zyklischen Voltammetrie zu einem ersten Zeitpunkt;
- Ermittlung eines zweiten Voltammogramms (21, 22) mittels einer weiteren zyklischen Voltammetrie zu einem bezüglich des ersten Zeitpunktes späteren zweiten Zeitpunkt;
- Ermittlung eines ersten Extremwertes (41) im ersten Voltammogramm (11, 12) und eines zweiten Extremwertes (42) im zweiten Voltammogramm (21, 22), wobei jedem Extremwert (41, 42) wenigstens eine Spannung U₁ bzw. U₂ und eine Stromstärke I₁ bzw. I₂ zugehörig ist, wobei der erste und/oder zweite Extremwert (41, 42) als ein Spitzenwert der Stromstärke im Spannungsbereich von 3.4 V bis 3.7 V festgelegt wird; und
- Bestimmung der Alterung ***SOH*** der Lithium-Ionen-Zelle in Abhängigkeit eines Unterschiedes zwischen dem ersten und zweiten Extremwert (41, 42).

2. Verfahren gemäß Anspruch 1, bei dem der Unterschied durch die numerische Differenz **Δ*U*** = ***U*₁ - *U*₂** der den Extremwerten (41, 42) zugehörigen Spannungen ***U*₁, *U*₂** gebildet wird.

3. Verfahren gemäß Anspruch 2, bei dem die Alterung ***SOH*** durch ***SOH* = 1 - |Δ*U*|/*U*₀** bestimmt wird, wobei ***U*₀** im Bereich von 10 mV bis 50 mV liegt.

4. Verfahren gemäß Anspruch 1, bei dem der Unterschied durch die numerische Differenz **Δ*I* = *I*₁ - *I*₂** der den Extremwerten (41, 42) zugehörigen Stromstärken ***I*₁, *I*₂** gebildet wird.

5. Verfahren gemäß Anspruch 4, bei dem die Alterung ***SOH*** durch ***SOH* = 1** - **|Δ*I*|/*I*₀** bestimmt wird, wobei ***I*₀** im Bereich von 100 mA bis 500 mA liegt.

6. Verfahren gemäß Anspruch 1, bei dem ein dritter Extremwert (43) im ersten Voltammogramm (11, 12) und ein vierter Extremwert (44) im zweiten Voltammogramm (21, 22) mit jeweils zugehörigen Spannungen U₃ bzw. U₄ und Stromstärken I₃ bzw. I₄ ermittelt wird, wobei der erste und zweite Extremwert (41, 42) einer Redoxreaktion und der dritte und vierte Extremwert (43, 44) einer Oxidationsreaktion der Lithium-Ionen-Zelle zugeordnet sind.

7. Verfahren gemäß Anspruch 6, bei dem der Unterschied durch die numerische Differenz **(*I*₁ + |*I*₃|)** - **(*I*₂ - |*I*₄|)** gebildet wird.

8. Verfahren gemäß Anspruch 6, bei dem der Unterschied durch den numerischen Quotienten **[*I*₂/(*I*₂ + *I*₄)]/[*I*₁/(*I*₁ + *I*₃₎]** gebildet wird.

9. Verfahren gemäß Anspruch 6, bei dem der Unterschied durch den numerischen Quotienten **(*I*₁ - *I*₃)/(*I*₂** - ***I*₄)** gebildet wird.

10. Verfahren gemäß Anspruch 6, bei dem der Unterschied durch den Winkel **Δ*α*** (31) zwischen einer ersten und zweiten Geraden (61, 62) gebildet wird, wobei die erste Gerade (61) durch den ersten und dritten Extremwert (41, 43) im ersten Voltammogramm (11, 12) und die zweite Gerade (62) durch den zweiten und vierten Extremwert (42, 44) im zweiten Voltammogramm (21, 22) festgelegt wird.

11. Verfahren gemäß Anspruch 10, bei dem die Alterung ***SOH*** durch ***SOH*** = **1** - **|Δ*α*|/α₀** bestimmt wird, wobei ***α*₀** im Bereich von 5 Grad bis 15 Grad liegt.

12. Verfahren gemäß einem der vorhergehenden Ansprüche, bei dem als Spannungsvorschub der einen und/oder der weiteren zyklischen Voltammetrie (21, 22) ein Wert im Bereich von 0,01 mV/s bis 0,03 mV/s verwendet wird.

13. Verfahren gemäß einem der vorhergehenden Ansprüche, bei dem als Lithium-Ionen-Zelle ein Energiespeicher eines Luftfahrzeuges, insbesondere eines Elektroflugzeuges, verwendet wird.

## Claims

1. Method for determining the aging ***SOH*** of a lithium-ion cell, comprising the following steps:
- identification of a first voltammogram (11, 12) by means of a cyclic voltammetry process at a first time;
- identification of a second voltammogram (21, 22) by means of a further cyclic voltammetry process at a second time that is later relative to the first time;
- identification of a first extreme value (41) in the first voltammogram (11, 12) and of a second extreme value (42) in the second voltammogram (21, 22), wherein at least one voltage ***U₁*** or ***U*₂** and a current intensity ***I₁*** or ***I*₂** are associated with each extreme value (41, 42), wherein the first and/or second extreme value (41, 42) is set as a peak value of the current intensity in the voltage range of from 3.4 V to 3.7 V; and
- determination of the aging ***SOH*** of the lithium-ion cell depending on a difference between the first and second extreme value (41, 42).

2. Method according to Claim 1, in which the difference is formed by the numerical difference ***ΔU* = *U₁* - *U*₂** of the voltages ***U*₁, *U*₂** associated with the extreme values (41, 42).

3. Method according to Claim 2, in which the aging ***SOH*** is determined by ***SOH* = *1*** - **|*ΔU*|/*U₀,*** wherein ***U₀*** is in the range of from 10 mV to 50 mV.

4. Method according to Claim 1, in which the difference is formed by the numerical difference ***ΔI*** = ***I₁*** **-** ***I₂*** of the current intensities ***I₁, I*₂** associated with the extreme values (41, 42).

5. Method according to Claim 4, in which the aging ***SOH*** is determined by ***SOH* = *1*** - **|*ΔI*|/*I₀,*** wherein ***I₀*** is in the range of from 100 mA to 500 mA.

6. Method according to Claim 1, in which a third extreme value (43) in the first voltammogram (11, 12) and a fourth extreme value (44) in the second voltammogram (21, 22) with respectively associated voltages ***U₃*** or ***U₄*** and current intensities ***I₃*** or ***I₄*** are identified, wherein the first and second extreme value (41, 42) are assigned to a redox reaction and the third and fourth extreme value (43, 44) are assigned to an oxidation reaction of the lithium-ion cell.

7. Method according to Claim 6, in which the difference is formed by the numerical difference ***(I₁* + |*I₃*|*)* - *(I₂* - |*I₄*|*).***

8. Method according to Claim 6, in which the difference is formed by the numerical quotient ***[I₂*/*(I₂* + *I₄)]*/ *[I₁*/*(I₁* + *I₃)].***

9. Method according to Claim 6, in which the difference is formed by the numerical quotient ***(I₁* - *I₃)*/*(I₂* - *I₄).***

10. Method according to Claim 6, in which the difference is formed by the angle ***Δα*** (31) between a first and a second straight line (61, 62), wherein the first straight line (61) is set by the first and third extreme value (41, 43) in the first voltammogram (11, 12) and the second straight line (62) is set by the second and fourth extreme value (42, 44) in the second voltammogram (21, 22).

11. Method according to Claim 10, in which the aging ***SOH*** is determined by ***SOH* = *1*** - **|*Δα*|/*α₀,*** wherein ***α₀*** is in the range of from 5 degrees to 15 degrees.

12. Method according to one of the preceding claims, in which a value in the range of from 0.01 mV/s to 0.03 mV/s is used as the voltage scan rate of the one and/or the further cyclic voltammetry process (21, 22).

13. Method according to one of the preceding claims, in which an energy storage means of an aircraft, in particular of an electric aircraft, is used as the lithium-ion cell.

## Revendications

1. Procédé de détermination du vieillissement *SOH* d'une pile lithium-ion, comprenant les stades :
- détermination d'un premier voltamogramme (11, 12) au moyen d'une voltamétrie cyclique à un premier instant;
- détermination d'un deuxième voltamogramme (21, 22) au moyen d'une autre voltamétrie cyclique à un deuxième instant ultérieur au premier instant;
- détermination d'un premier extremum (41) du premier voltamogramme (11, 12) et d'un deuxième extremum (42) du deuxième voltamogramme (21, 22), chaque extremum (41, 42) étant associé au moins à une tension U₁ et U₂ et à une intensité I₁ et I₂ de courant, dans lequel on fixe le premier et/ou le deuxième extremum (41, 42) comme une valeur de crête de l'intensité du courant dans la plage de tension de 3,4 V à 3,7 V; et
- détermination du vieillissement *SOH* de l'élément lithium-ion en fonction d'une différence entre le premier et le deuxième extremum (41, 42).

2. Procédé suivant la revendication 1, dans lequel on forme la différence par la différence numérique Δ*U* = *U*₁ - *U*₂ des tensions *U*₁*, U*₂ associés aux extremums (41, 42).

3. Procédé suivant la revendication 2, dans lequel on détermine le vieillissement *SOH* par *SOH* = 1 - |Δ*U*|*U*₀*, U*₀ étant dans la plage de 10 mV à 50 mV.

4. Procédé suivant la revendication 1, dans lequel on forme la différence par la différence numérique **Δ*I* = *I*₁** - ***I*₂** des intensités ***I*₁, *I*₂** de courant associés aux extremums (41, 42).

5. Procédé suivant la revendication 4, dans lequel on détermine le vieillissement *SOH* par *SOH* = 1 - |Δ*I*|*I*₀, *I*₀ étant dans la plage de 100 mA à 500 mA.

6. Procédé suivant la revendication 1, dans lequel on détermine un troisième extremum (43) dans le premier voltamogramme (11, 12) et un quatrième extremum (44) dans le deuxième voltamogramme (21, 22), ayant chacun des tensions U₃ et U₄ et des intensités I₃ et I₄ de courant associées, le premier et le deuxième extremums (41, 42) étant associés à une réaction ridox et le troisième et le quatrième extremums (43, 44) a une réaction d'oxydation de l'élément lithium-ion.

7. Procédé suivant la revendication 6, dans lequel on forme la différence par la différence numérique (*I*₁ + |*I*₃|) - (*I*₂ - |*I*₄|).

8. Procédé suivant la revendication 6, dans lequel on forme la différence par le quotient numérique [*I*₂/(*I*₂ + *I*₄)]/[*I*₁/(*I*₁ + *I*₃)].

9. Procédé suivant la revendication 6, dans lequel on forme la différence par le quotient numérique (*I*₁ - *I₃*)/(*I*₂ - *I*₄)

10. Procédé suivant la revendication 6, dans lequel on forme la différence par l'angle Δ*α* (31) entre une première et une deuxième droite (61, 62), la première droite (61) passant par le premier et le troisième extremum (41, 43) du premier voltamogramme (11, 12) et la deuxième droite (62) par le deuxième et le quatrième extremum (42, 44) dans le deuxième voltamogramme (21, 22).

11. Procédé suivant la revendication 10, dans lequel on détermine le vieillissement *SOH* par *SOH* = 1 - |Δ*α*|/*α*₀, *α*₀ étant dans la plage de 5 degrés à 15 degrés.

12. Procédé suivant l'une des revendications précédentes, dans lequel on utilise, comme avance de tension, de l'une et/ou de l'autre votamétrie (21, 22) cyclique, une valeur dans la plage de 0,01 mV/s à 0,03 mV/s.

13. Procédé suivant l'une des revendications précédentes, dans lequel on utilise, comme élément lithium-ion, un accumulateur d'énergie d'un aéronef, notamment d'un aéronef électrique.
